Europäisches Patentamt

European Patent Office

Office européen des brevets

(19)

(11) Numéro de publication: **0 002 406**
**B1**

(12) **FASCICULE DE BREVET EUROPEEN**

(45) Date de publication du fascicule du brevet: **14.07.82**

(51) Int. Cl.³: **H 01 J 37/08, H 01 J 27/26**

(21) Numéro de dépôt: **78400190.1**

(22) Date de dépôt: **17.11.78**

(54) Source d'ions notamment pour implanteur ionique.

(30) Priorité: **28.11.77 FR 7735760**

(43) Date de publication de la demande:
**13.06.79 Bulletin 79/12**

(45) Mention de la délivrance du brevet:
**14.07.82 Bulletin 82/28**

(84) Etats contractants désignés:
**CH DE GB NL**

(56) Documents cités:
**FR - A - 1 420 531**
**FR - A - 1 487 438**
**FR - A - 2 063 256**
**FR - A - 2 064 480**
**FR - A - 2 082 091**

(73) Titulaire: **ANVAR Agence Nationale de Valorisation de la Recherche**
**13, rue Madeleine Michelis**
**F-92522 Neuilly-sur-Seine (FR)**

(72) Inventeur: **Camplan, Jean**
**37, Boulevard Garibaldi**
**F-75015 Paris (FR)**
Inventeur: **Chaumont, Jacques**
**4, Square Arago**
**F-78330 Fontenay Le Fleury (FR)**
Inventeur: **Meunier, Robert**
**9, Chemin à Dieu**
**F-78830 Bonnelles (FR)**

(74) Mandataire: **Mongrédien, André et al,**
**c/o Brevatome 25, rue de Ponthieu**
**F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

Source d'ions notamment pour implanteur ionique.

La présente invention a pour objet une source d'ions. Elle trouve une application notamment dans la réalisation d'implanteurs ioniques destinés par exemple à la fabrication des semiconducteurs.

On sait qu'un implanteur ionique comprend essentiellement une source d'ions, des moyens d'extraction et d'accélération des ions formés, un analyseur de masse et des moyens de balayage d'une cible par les ions. La source d'ions peut être de différents types, mais elle est généralement constituée par une chambre à décharge dans laquelle un plasma est entretenu par une excitation électrique appliquée à partir d'une cathode en forme d'hélice baignant dans un champ magnétique de confinement. Un gaz approprié est introduit dans la chambre, par exemple $PF_5$ ou $BF_3$ ou $AsF_3$. Sous l'effet de l'excitation électrique, le gaz s'ionise et donne naissance à des ions dont la nature dépend du gaz utilisé. On pourra consulter à ce sujet le brevet français 2 064 480 déposé le 15 septembre 1969.

Dans certaines applications et particulièrement dans l'implantation d'ions dans du silicium en vue de la fabrication de semiconducteurs, il est primordial que la source d'ions ne donne naissance à aucun ion cuivre ou argent et plus généralement à aucun ion de métaux lourds bons conducteurs, car ces métaux constituent des poisons voilents pour le silicium.

Le problème s'est donc posé de réaliser des sources d'ions ne présentant pas cet inconvénient. Le cuivre peut être facilement banni de la chambre d'ionisation proprement dite, car la cathode est généralement constituée en tungstène et l'enceinte de la chambre en graphite. Mais il n'en est pas de même pour les amenées de courant qui doivent permettre le passage de 150 A. Le recours à un métal comme le cuivre dont la conductibilité électrique est exceptionnellement bonne est donc, sinon une nécessité, du moins une facilité à laquelle on a largement eu recours jusqu'à présent.

La publication de brevet français FR—A— 2 064 480 décrit une source d'ions comprenant, une anode (11) délimitant une chambre d'ionisation (9), dans laquelle se trouve une cathode (10) en forme de filament présentant deux extrémités traversant l'anode. Deux amenées de courant constituées par des tiges en cuivre (15) sont reliées chacune à une extrémité du filament. Un double cylindre (7), réalisé en une seule pièce et se terminant par une bride (8) permet de fermer l'installation de façon étanche et de créer un volume sous vide qui est en communication avec la chambre d'ionisation. Les tiges en cuivre (15) traversent ce cylindre (7) par des douilles d'étanchéité (16).

Une telle source n'est pas exempte du défaut signalé. En effet, l'extrémité de chaque tige en cuivre (15) est directement reliée à une extrémité du filament (10) de sorte que l'extrémité de chaque tige en cuivre est présente dans le volume sous vide. Une telle source engendre donc fatalement des ions cuivre.

L'invention permet de remédier à cet inconvénient sans renoncer au cuivre pour constituer les conducteurs d'amenée de courant. En plus de cet avantage principal, l'invention procure celui d'une grande simplicité des opérations de montage-démontage de la source ainsi que celui d'une grande facilité de maintenance.

De façon précise, l'invention a pour objet une source d'ions comprenant un corps délimitant une chambre à décharge, un filament émissif disposé dans la chambre et présentant deux extrémités traversant ledit corps, deux amenées de courant reliées chacune à une extrémité du filament, un flasque muni de deux passages étanches au vide traversés par les deux amenées de courant, ce flasque étant apte à se fixer sur une enceinte à vide délimitant un volume sous vide en communication avec ladite chambre; cette source est caractérisée en ce que chaque amenée de courant comprend un tube métallique traversant ledit passage étanche et ayant une extrémité fermée par un pièce métallique elle-même reliée à une extrémité du filament émissif, ce tube étant réalisé en un métal autre qu'un métal lourd et contenant un conducteur en métal lourd bon conducteur de l'électricité, notamment en cuivre, ce conducteur ayant une extrémité fixée dans ladite pièce métallique.

Grâce à cette disposition, le cuivre utilisé dans la source de l'invention est isolé de l'enciente à vide et ne peut, par conséquent, donner naissance à aucun ion dans ladite enceinte.

Bien que des matériaux divers puissent être utilisés pour constituer le tube extérieur, dans une variante avantageuse de réalisation, on utilise un métal autre que le cuivre et l'argent et notamment l'acier inoxydable.

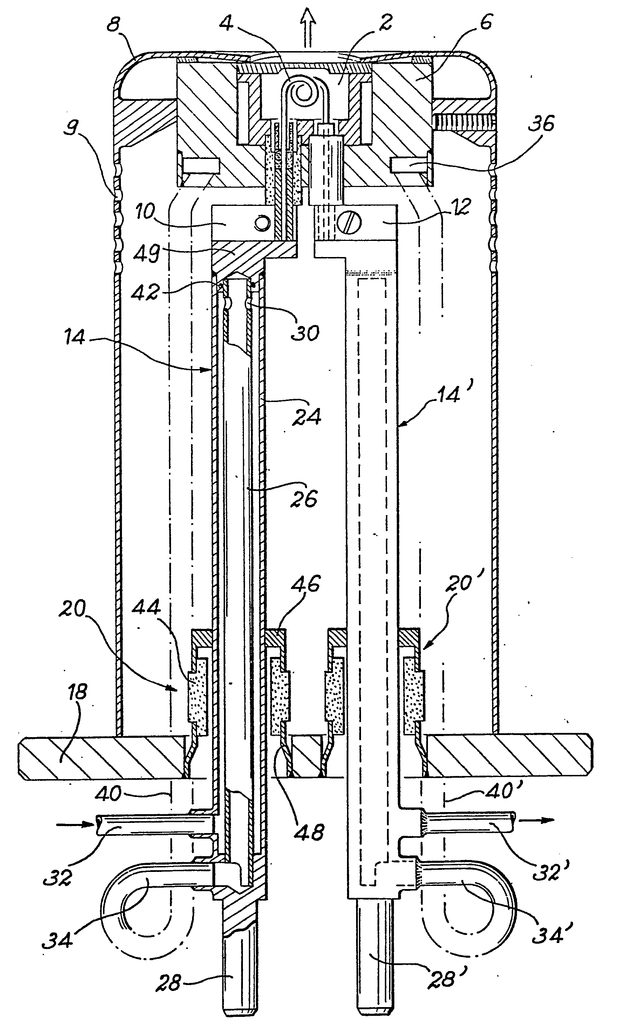

De toutes façons, les caractéristiques et avantages de l'invention apparaîtront mieux après la description qui suit d'un exemple de réalisation donné à titre explicatif et nullement limitatif, en référence à la figure unique qui représente une coupe schématique de la source d'ions de l'invention.

La source représentée sur la figure comprend une chambre à décharge 2 dans laquelle est disposée une cathode 4 en forme d'hélice, l'ensemble étant entouré d'un corps massif 6. Les extrémités de la cathode 4 sont fixées à deux pièces métalliques 10 et 12 supportées par deux éléments tubulaires 14 et 14' qui traversent un flasque 18 par des passages étanches 20 et 20'. En fonctionnement, le flasque vient se fixer sur une enciente non représentée qui est reliée à l'implanteur.

La pièce massive 6 et différents éléments de la chambre d'ionisation sont reliés à un capot 8 percé d'ouvertures 9 qui vient prendre appui sur le flasque 18.

Selon l'invention, les éléments tubulaires 14 et 14' sont constitués, d'une part, par un tube 24 métallique, par exemple en acier inoxydable, à l'intérieur duquel est disposé un conducteur en cuivre 26. Chaque tube extérieur est relié à l'un des passages étanches et chaque conducteur central est relié, par son extrémité 28 (28') à des connexions d'arrivée de courant non représentées.

De manière avantageuse, le conducteur central en cuivre présente la forme d'un tube qui délimite avec le tube extérieur 24 un volume annulaire que l'on fait communiquer avec le volume intérieur du tube central par des ouvertures 30 percées à celle des extrémités du tube 26 qui est la plus proche de la cathode. Ces volumes peuvent être utilisés pour constituer un circuit de refroidissement des amenées de courant. Dans cette variante, le tube en cuivre 26 sert donc à la fois de connexion électrique et de conduit de liquide de refroidissement. A cette fin, deux conduits 32 et 34 (32' et 34') sont reliés à l'élément tubulaire 14 (14'). Si la pièce massive 6 doit être également refroidie, elle est percée d'un canal 36 dans lequel est introduit un liquide de refroidissement grâce à des conduits 40 et 40'. Avantageusement, le conduit 34 est réuni au conduit 40, de même que le conduit 34' est réuni au conduit 40', de sorte qu'un circuit unique de refroidissement est ainsi constitué entre l'amenée 14, le canal 36 et l'amenée 14'.

Le montage de l'ensemble illustré est particulièrement simple. Le tube intérieur en cuivre 26 est d'abord fixé par une extrémité au tube en inox 24 par l'intermédiaire d'une pièce 49, par exemple par une brasure à l'argent 42. L'ensemble est monté sur un passage étanche qui comprend un cylindre en matière électriquement isolante 44, par example en verre ou en alumine, et deux pièces métalliques de transition 46 et 48, par exemple en kovar; le tube 46 est brasé sur le tube en inox. L'ensemble est ensuite disposé sur le flasque 18 et la pièce 48 est soudée sur le flasque 18, par exemple par argon-arc.

Le filament peut être facilement démonté puisqu'il suffit de dévisser les pièces 10 et 12 qui supportent les deux extrémités du filament.

On remarquera que, dans cette disposition les pièces des passages étanches présentent leur partie extérieure au vide, de sorte que lorsque ces parties sont polluées par des dépôts métalliques provenant des ions émis par la source, leur nettoyage ne pose pas de problème. La maintenance de la source d'ions s'en trouve donc facilitée.

## Revendications

1. Source d'ions comprenant un corps (6) délimitant une chambre à décharge (2), un filament émissif (4) disposé dans la chambre et présentant deux extrémités traversant ledit corps, deux amenées de courant (14, 14') reliées chacune à une extrémité du filament, un flasque (18) muni de deux passages étanches au vide (20, 20') traversés par les deux amenées de courant (14, 14'), ce flasque étant apte à se fixer sur une enceinte à vide délimitant un volume sous vide en communication avec ladite chambre, caractérisée en ce que chaque amanée de courant comprend un tube métallique (24) traversant ledit passage étanche (20, 20') et ayant une extrémité fermée par une pièce métallique (49) elle-même reliée à une extrémité du filament émissif, ce tube étant réalisé en un métal autre qu'un métal lourd et contenant un conducteur (26) en métal lourd bon conducteur de l'électricité, notamment en cuivre, ce conducteur ayant une extrémité fixée dans ladite pièce métallique (49).

2. Source d'ions selon la revendication 1, caractérisée en ce que le conducteur (26) présente la forme d'un tube qui ménage avec le tube métallique (24) une zone annulaire, laquelle communique avec le volume intérieur du conducteur (26) par au moins un orifice (30), deux conduits (32, 34) de circulation de liquide de refroidissement étant reliés respectivement au tube métallique (24) et au conducteur (26).

3. Source d'ions selon la revendication 2, caractérisée en ce que le corps est percé d'un canal (36) relié à deux conduits (40, 40') de circulation d'un liquide de refroidissement, lesdits conduits (40, 40') étant eux-mêmes reliés en série aux conduits (32, 34) de circulation de liquide de refroidissement dans les amenées de courant.

4. Source d'ions selon l'une quelconque des revendications 1 à 43, caractérisée et ce que chaque passage étanche au vide (20, 20') comprend un cylindre (44) en matériau électriquement isolant, relié par une pièce métallique de transition (48) au flasque (18) et par une autre pièce métallique de transition (46) au tube métallique (24) de l'amenée de courant traversant ce passage, ledit passage présentant sa surface extérieure au vide et sa surface intérieure à l'atmosphère ambiante.

## Patentansprüche

1. Ionenquelle bestehend aus einem eine Entladungskammer (2) begrenzenden Körper (6), einem Emissionsfaden (4), der in der Kammer angeordnet ist und zwei durch den Körper hindurchgehende Enden aufweist, zwei Stromzuführungen (14, 14'), die mit je einem Ende des Heizfadens verbunden sind, und einem mit zwei vakuumdichten Durchführungen (20, 20') versehenen Flansch (18), durch die die zwei Stromzuführungen (14, 14') hindurchgeführt sind, wobei der Flansch an einem ein Vakuum aufweisenden Raum befestigbar ist, welcher ein mit der Kammer in Verbindung stehendes, ein Vakuum aufweisendes Volumen begrenzt, dadurch gekennzeichnet, daß jede Stromzuführung ein Metallrohr (24) umfaßt, die durch die dichte Durchführung (20, 20') hindurchgeht und ein durch ein metallisches Teil (49) geschlossenes Ende aufweist, welches selbst mit einem Ende des Emissionsfadens verbunden ist, wobei dieses Rohr aus einem von einem Schwermetall verschiedenen Metall besteht und einen Leiter (26) aus einem Schwermetall mit guter elektrischer Leitfähigkeit enthält, insbesondere aus Kupfer, und daß eine Ende des Leiters in dem metallischen Teil (49) befestigt ist.

2. Ionenquelle nach Anspruch 1, dadurch gekennzeichnet, daß der Leiter (26) die Form eines Rohres hat, welches mit dem Metallrohr (24) eine Ringzone einschließt, die über mindestens eine Öffnung (30) mit dem inneren Volumen des Leiters (26) in Verbindung steht, und daß zwei Leitungen (32, 34) des Kühlflüssigkeitskreislaufes mit dem Metallrohr (24) bzw. dem Leiter (26) verbunden sind.

3. Ionenquelle nach Anspruch 2, dadurch gekennzeichnet, daß der Körper von einem mit zwei Leitungen (40, 40') des Kühlflüssigkeitskreislaufes verbundenen Kanal (36) durchdrungen ist und daß die zwei Leitungen (40, 40') in Reihe mit den Leitungen (32, 34) des Kühlflüssigkeitskreislaufes in den Stromzuführungen verbunden sind.

4. Ionenquelle nach einem der Ansprüche 1 bis 3, dadurch gekennzeichnet, daß jede vakuumdichte Durchführung (20, 20') einen Zylinder (44) aus einem elektrisch isolierenden Material umfaßt, der mittels eines metallenen Übergangsstückes (48) mit dem Flansch (18) und eines anderen metallischen Übergangsstückes (46) mit dem Metallrohr (24) der durch die Durchführung hindurchgehenden Stromzuführung verbunden ist, wobei die äußere Oberfläche der Durchführung zu dem Vakuum und die innere Oberfläche zu der umgebenden Atmosphäre weist.

**Claims**

1. Ion source comprising a body (6) delimiting a discharge chamber (2), an emissive filament (4) located in said chamber and having two ends passing through said body, two current leads (14, 14') each connected to a respective end of the filament, a flange (18) having two vacuum-tight passages (20, 20') through which pass the two current leads (14, 14'), said flange being adapted to be fixed in a vacuum enclosure delimiting a volume under vacuum communicating with said chamber, characterzied in that each current lead comprises a metallic tube (24) pass-ing through the said vacuum-tight passage (20, 20') and having an end closed by a metallic piece (49) which is itself connected to an end of the emissive filament, said tube being formed from a metal other than a heavy metal and containing a conductor (26) made from a heavy metal which is a good conductor of electricity, especially of copper, said conductor having an end fixed in said metallic piece (49).

2. Ion source according to Claim 1 characterized in that the conductor (26) is in the form of a tube that, with the metallic tube (24), defines an annular zone which communicates with the interior space of the conductor (26) by at least one orifice (30), two conduits (32, 34) for circulation of cooling fluid being connected respectively to the metallic tube (24) and the conductor (26).

3. Ion source according to Claim 2 characterized in that the body is pierced by a channel (36) connected to two conduits (40, 40') for circulation of a cooling fluid, said conduits (40, 40') being themselves connected in series with conduits (32, 34) for circulation of cooling fluid in the current conductors.

4. Ion source according to any one of claims 1 to 3 characterized in that each vacuum-tight passage (20, 20') comprises a cylinder (44) of electrically-insulating material, connected by a metallic transition-piece (48) to the flange (18) and by another metallic transition-piece (46) to the metallic tube (24) of the current lead pass-ing through the passage, said passage having its exterior surface directed towards vacuum and its interior surface directed towards the ambient atmosphere.

0 002 406

1